Europäisches Patentamt

European Patent Office

Office européen des brevets

(11) Veröffentlichungsnummer : **0 092 151**
**B1**

(12) # EUROPÄISCHE PATENTSCHRIFT

(45) Veröffentlichungstag der Patentschrift :
17.07.85

(51) Int. Cl.⁴ : **G 01 R 19/145**

(21) Anmeldenummer : 83103544.9

(22) Anmeldetag : 13.04.83

(54) Vorrichtung zur optischen Anzeige des Betriebszustandes eines Energieversorgungsnetzes.

(30) Priorität : 20.04.82 DE 3214484

(43) Veröffentlichungstag der Anmeldung :
26.10.83 Patentblatt 83/43

(45) Bekanntmachung des Hinweises auf die Patenterteilung : 17.07.85 Patentblatt 85/29

(84) Benannte Vertragsstaaten :
AT BE CH FR GB IT LI LU NL SE

(56) Entgegenhaltungen :
EP-A- 0 012 285
DE-A- 2 854 415
DE-A- 2 909 060
FR-A- 1 395 898
US-A- 1 928 951

(73) Patentinhaber : Karl Pfisterer Elektrotechnische Spezialartikel GmbH & Co. KG
Augsburger Strasse 375
D-7000 Stuttgart 60 (DE)

(72) Erfinder : Schuster, Martin
Heidestrasse 51
D-7300 Esslingen (DE)
Erfinder : Bachmeier, Albert
Römersteinweg 17
D-7067 Plüderhausen (DE)
Erfinder : Schächterle, Werner
Forststrasse 26
D-7057 Winnenden (DE)

(74) Vertreter : Patentanwälte Phys. Bartels Dipl.-Ing. Fink
Dr.-Ing. Held
Lange Strasse 51
D-7000 Stuttgart 1 (DE)

**Beschreibung**

Die Erfindung betrifft eine Vorrichtung zur optischen Anzeige des Betriebszustandes eines wegen einer Isolation, Kapselung od. dgl. unzugänglichen Leiters eines Energieversorgungsnetzes, die über eine Steckverbindung, bestehend aus einem an der Vorrichtung vorgesehenen Steckerteil und einem an einem Träger vorgesehenen Steckbuchsenteil, mit einem an den Steckbuchsenteil angeschlossenen Spannungssensor und/oder Stromsensor verbindbar ist. Bei dem Träger kann es sich beispielweise um das Gehäuse einer gekapselten Anlage oder um eine an einem Kabelende angeordnete Garnitur handeln.

Die bekannten Vorrichtungen dieser Art (DE-A-28 54 415, DE-A-29 09 060), welche der Anzeige des Betriebszustandes eines isolierten Kabels dienen, ermöglichen zwar eine zeitweilige oder ständige Überwachung und Anzeige in besonders einfacher und gefahrloser Weise selbst unter ungünstigen äußeren Bedingungen. Eine Überprüfung der Funktionsfähigkeit dieser bekannten Vorrichtungen ist jedoch an Ort und Stelle nicht möglich.

Der Erfindung liegt daher die Aufgabe zugrunde, eine Vorrichtung der eingangs genannten Art zu schaffen, deren Funktionsfähigkeit jederzeit an Ort und Stelle überprüft werden kann. Diese Aufgabe löst eine Vorrichtung mit den Merkmalen des Anspruches 1.

Die Bedienungsperson braucht für die Prüfung der Funktionsfähigkeit der erfindungsgemäßen Vorrichtung nur deren Stecker in eine übliche Steckdose des Niederspannungs-Energieversorgungsnetzes, das normalerweise eine Spannung von 220 Volt führt, einzusetzen. Die Netzspannung bewirkt dann eine Anzeige, wenn die Vorrichtung funktionsfähig ist. Da üblicherweise in denjenigen Räumen, in denen sich normalerweise die zu überwachenden Leitungen befinden, eine ausreichende Anzahl von Steckdosen vorhanden ist, sind in der Regel nur wenige Schritte von der Einsatzstelle der Vorrichtung zu der nächstliegenden Steckdose erforderlich.

Vorzugsweise ist die Schaltung der erfindungsgemäßen Vorrichtung mit den Kontaktstiften des Steckers direkt und ständig, also ohne Zwischenschaltung eines Schalters, verbunden, damit zur Funktionsprüfung kein Schalter betätigt zu werden braucht.

Eine Ausbildung des Steckers als Schukostecker ergibt den Vorteil, daß die Steckverbindung auch relativ große mechanische Kräfte aufzunehmen vermag. Da das Gewicht der Vorrichtung jedoch sehr gering gehalten werden kann und nennenswerte äußere Kräfte an der Vorrichtung nicht angreifen, genügt aber auch eine Ausbildung des Steckers als Europastecker, welcher es ermöglicht, die Funktionsprüfung an allen üblichen Steckdosen vornehmen zu können.

Im folgenden ist die Erfindung anhand eines in der Zeichnung dargestellten Ausführungsbeispiels im einzelnen erläutert. Es zeigen :

Figur 1 eine Seitenansicht des Ausführungsbeispiels,

Figur 2 eine Draufsicht auf die Rückseite des Ausführungsbeispiels,

Figur 3 eine Draufsicht auf die Vorderseite des Ausführungsbeispiels,

Figur 4 eine Seitenansicht eines Kabelsteckers und des an diesen angesetzten Ausführungsbeispiels.

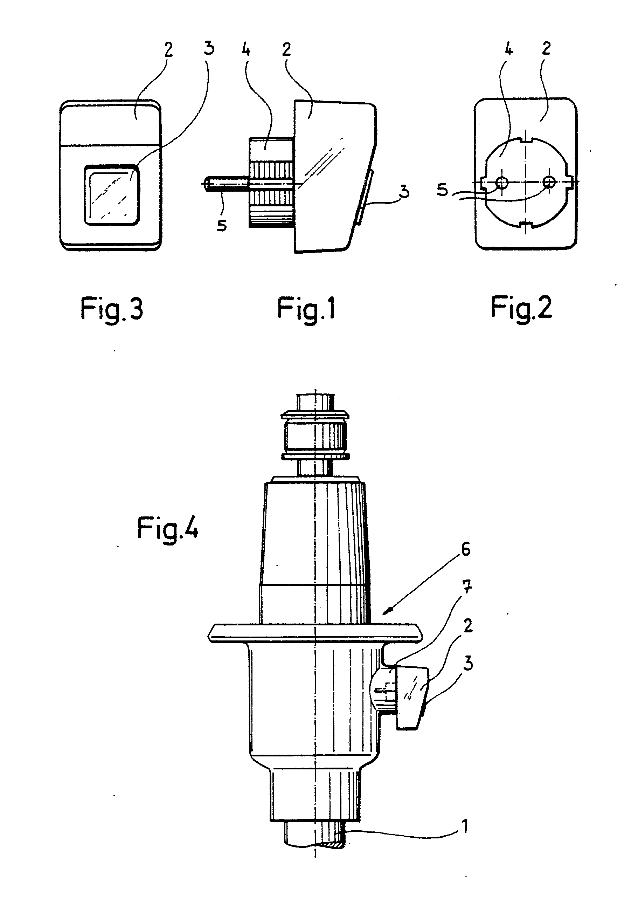

Eine Vorrichtung zur optischen Anzeige des Betriebszustandes eines isolierten Kabels 1 eines Energieversorgungsnetzes, dessen Betriebsspannung im Bereich zwischen 10 kV und 50 kV liegt, weist ein Gehäuse 2 auf, das, wie die Fig. 1 bis 3 zeigen, im Ausführungsbeispiel von einer Quaderform nur dadurch abweicht, daß die Ecken abgerundet und ein Teil der Vorderseite pultartig abgeschrägt ist. Der Raumbedarf der im Gehäuse 2 unterzubringenden Bauelemente und Verbindungen ist gering, so daß beispielsweise Abmessungen in der Größenordnung von 60 mm mal 40 mm mal 30 mm für das Gehäuse ausreichen.

Der pultartig abgeschrägte Teil der Vorderwand des Gehäuses 2 trägt eine Anzeigeeinrichtung 3, bei welcher es sich um eine LCD-Anzeigeeinrichtung handeln kann, um für den Betrieb der Vorrichtung keine Fremdenergiequelle zu benötigen. Es könnte aber auch eine Glimmlampe als Anzeigeeinrichtung Verwendung finden, falls nur zwischen zwei Betriebszuständen unterschieden zu werden braucht, also beispielsweise zwischen dem Betriebszustand, daß das Kabel 1 die Betriebsspannung führt und dem Betriebszustand, daß es vom Netz abgetrennt und spannungsfrei ist. Der Aufbau der im Gehäuse 2 enthaltenen Schaltung ist ebenfalls davon abhängig, welche Betriebszustände des Kabels 1 angezeigt werden sollen. Soll beispielsweise zwischen der Betriebsspannung des Kabels und seiner Ladespannung nach dem Abtrennen vom Netz unterschieden werden, dann ist eine an sich bekannte logische Schaltung erforderlich, welche die hierzu notwendige Differenzierung zwischen den beiden genannten Betriebszuständen vornehmen kann. Entsprechendes gilt dann, wenn eine Stromüberwachung folgen soll, um einen Überstrom oder Kurzschlußstrom anzuzeigen. Auch die hierfür erforderliche Elektronik ist bekannt. Im Ausführungsbeispiel wird die zum Betrieb der Anzeigeeinrichtung 3 erforderliche Spannung an einem Kondensator abgegriffen, der über einen Strombegrenzungswiderstand und einen Gleichrichter geladen wird.

Wie insbesondere Fig. 1 zeigt, ist an der Rückseite des Gehäuses 2 ein Schukostecker 4 vorgesehen, der wie die üblichen Schukostecker einen im wesentlichen zylindrischen Sockel aufweist, der fest mit dem Gehäuse 2 verbunden oder mit diesem einstückig ausgebildet ist. Aus der dem Gehäuse 2 abgekehrten Stirnseite des Sockels ragen die beiden Steckerstifte 5 heraus, deren Durchmesser und Abstand der gleiche ist wie bei den üblichen Schukosteckern. Der Schukostecker 4 kann deshalb in jede Schuko-Steckdose eingesteckt werden.

Da der aus dem Kondensator, dem Gleichrichter und dem Strombegrenzungswiderstand bestehende Stromkreis, über den die Anzeigeeinrichtung 3 angesteuert und mit Energie versorgt wird, an die beiden Steckerstifte 5 angeschlossen ist und der Strombegrenzungswiderstand so gewählt ist, daß er den Strom auf denjenigen Wert begrenzt, der auch fließt, wenn das zu überwachende Kabel seine Betriebsspannung führt, kann die Funktionsfähigkeit der Vorrichtung dadurch geprüft werden, daß man den Schukostecker 4 in eine Schuko-Steckdose der vorhandenen Niederspannungs-Installation einsetzt. Zeigt dabei die Anzeigeeinrichtung 3 das Vorhandensein der Betriebsspannung an, dann funktioniert die Vorrichtung ordnungsgemäß.

Um mit dieser Vorrichtung überwachen und anzeigen zu können, ob das isolierte Kabel 1 seine Betriebsspannung führt oder spannungsfrei ist, enthält ein am einen Ende dieses Kabels 1 montierter Kabelstecker 6 eine an die Kabelseele angekoppelte Elektrode. Außerdem ist der Kabelstecker 6 mit einer Schuko-Steckdose 7 versehen, deren isolierende Teile im Ausführungsbeispiel einstückig mit dem Gehäuse des Kabelsteckers 6 ausgebildet sind. Die beiden Buchsen der Schuko-Steckdose 7, in welche die Steckerstifte 5 eingesteckt werden können, sind mit der an die Kabelseele angekoppelten Elektrode bzw. Erde verbunden. Die Anzeigeeinrichtung 3 zeigt daher das Vorhandensein einer Betriebsspannung an, wenn das Kabel 1 seine Betriebsspannung führt und dementsprechend der an die Aderseele angekoppelte Kondensator aufgeladen ist, so daß dieser den Ladestrom liefert, der für die Auflagung des im Gehäuse 2 enthaltenen Kondensators erforderlich ist, an welchen die Anzeigeeinrichtung 3 angeschlossen ist.

## Patentansprüche

1. Vorrichtung zur optischen Anzeige des Betriebszustandes eines wegen einer Isolation, Kapselung od. dgl. unzugänglichen Leiters (1) eines Energieversorgungsnetzes, die über eine Steckverbindung (4, 7), bestehend aus einem an der Vorrichtung vorgesehenen Steckerteil (4) und einem an einem Träger vorgesehenen Steckbuchsenteil (7), mit einem an den Steckbuchsenteil (7) angeschlossenen Spannungssensor und/oder Stromsensor verbindbar ist, dadurch gekennzeichnet, daß der Steckerteil (4) als ein zum Zwecke der Funktionsprüfung der Vorrichtung in eine übliche Steckdose eines Niederspannungs-Energieversorgungsnetzes einsetzbarer Stecker (4) ausgebildet ist.

2. Vorrichtung nach Anspruch 1, dadurch gekennzeichnet, daß ihre Schaltung mit den Kontaktstiften (5) des Steckers (4) direkt und ständig verbunden ist.

3. Vorrichtung nach Anspruch 1 oder 2, dadurch gekennzeichnet, daß der Stecker (4) die Form eines Schuko-Steckers oder eines Europa-Steckers hat.

## Claims

1. Apparatus for optically surveying the operational condition of an energy supply network cable which is inaccessible by virtue of insulation, encapsulation or the like, which apparatus is connectable via a plug connection (4, 7) consisting of a plug part (4) provided on the apparatus and a socket part (7) provided on a carrier, with a voltage sensor and/or current sensor connected to the socket part (7), characterised in that the plug part (4) is formed as a plug (4) for the purpose of checking the function of the apparatus and which is insertable into a conventional socket of a low tension energy supply network.

2. Apparatus according to claim 1, characterised in that its connection with the contact pins (5) of the plug (4) is direct and continuous.

3. Apparatus according to claim 1 or 2, characterised in that the plug (4) has the form of an earthing-pin or a European-plug.

## Revendications

1. Dispositif pour indiquer visuellement la condition d'exploitation d'un conducteur (1) d'un réseau fournisseur d'énergie, inaccessible à cause d'une isolation, d'un encapsulage ou élément analogue, qui peut être raccordé, par l'intermédiaire d'une liaison enfichable (4, 7) se composant d'une partie formant fiche (4) prévue sur le dispositif et d'une partie formant prise (7) prévue sur un support, à un détecteur de tension et/ou un détecteur de courant raccordé à ladite partie formant prise (7), caractérisé par le fait que la partie formant fiche (4) est réalisée sous la forme d'une fiche (4) pouvant être introduite dans une prise courante d'un réseau d'alimentation en énergie de basse tension, en vue de vérifier l'aptitude fonctionnelle du dispositif.

2. Dispositif selon la revendication 1, caractérisé par le fait que son circuit est raccordé directement et en permanence aux broches de contact (5) de la fiche (4).

3. Dispositif selon la revendication 1 ou 2, caractérisé par le fait que la fiche (4) a la forme d'une fiche à contact de protection ou d'une fiche européenne.

0 092 151

Fig.3  Fig.1  Fig.2

Fig.4